# EUROPÄISCHE PATENTSCHRIFT

(11) **EP 3 170 958 B1**
(45) Veröffentlichungstag und Bekanntmachung des Hinweises auf die Patenterteilung: **21.11.2018**
(21) Anmeldenummer: 16204025.7
(22) Anmeldetag: 09.05.2014
(51) Int. Cl.: E05F 15/611, E05D 15/46, A47B 88/457, H03K 17/965, H03K 17/96

(54) **BEHÄLTNIS UND VERFAHREN ZUM AUSLÖSEN EINER ANTRIEBSVORRICHTUNG DES BEHÄLTNISSES**
CONTAINER AND METHOD FOR TRIGGERING A DRIVE DEVICE OF THE CONTAINER
CONTENEUR ET PROCÉDÉ PERMETTANT DE DÉCLENCHER UN DISPOSITIF D'ENTRAÎNEMENT DU CONTENEUR

(30) Priorität: 11.05.2013 DE 102013104866
(43) Veröffentlichungstag der Anmeldung: 24.05.2017
(62) Teilanmeldung aus: 14723769.7
(73) Patentinhaber: Kesseböhmer Holding KG, 49152 Bad Essen (DE)
(72) Erfinder: BARKAU, René, 49179 Ostercappeln (DE)
(74) Vertreter: Neumann Müller Oberwalleney & Partner Patentanwälte

(56) Entgegenhaltungen:
- WO-A1-2005/058092
- WO-A2-02/37516
- WO-A2-2008/141348

## Beschreibung

Die Erfindung betrifft ein Behältnis nach dem Oberbegriff des Anspruchs 1.

Ein solches Behältnis ist aus der WO 2005/058092 A1 bekannt.

Ein Möbel einer anderen Art ist aus der WO 2008/141348 A2 bekannt. Das Möbel weist ein erstes Element in Form eines Möbelkorpus und ein zweites Element in Form einer bewegbaren Klappe auf. Mittels der Antriebsvorrichtung kann die Klappe automatisch in eine Offen- und in eine Schließlage überführt werden. Zum Betätigen, d.h. zum Einschalten der Antriebsvorrichtung, ist ein Schaltelement vorgesehen. Das Schaltelement ist derart angeordnet und ausgebildet, dass durch eine vom Benutzer verursachte Bewegung der Klappe die Antriebsvorrichtung ausgelöst wird. Hierbei ist die Klappe in ihrer Schließlage derart angeordnet, dass es das Schaltelement überdeckt und an diesem anliegt. Durch Druckausübung auf die Klappe in Richtung zum Möbelkorpus wird ein Druckschalter des Schaltelements geschaltet und die Antriebsvorrichtung ausgelöst. Hierbei ist ein genügend großer Einrückweg für den Druckschalter und damit für die Klappe vorzusehen, der zwischen der Klappe und dem Möbelkorpus vorhanden sein muss. Dies kann zum Beispiel durch einen Federpuffer sichergestellt werden. Nachteilig kann sich auswirken, dass bei jedem Druck auf die Klappe die Antriebsvorrichtung ausgelöst wird und die Klappe in die Öffnungslage überführt, selbst wenn die Klappe unbeabsichtigt eingerückt wurde. Alternativ schlägt WO 2008/141348 A2 vor, eine Positionsmesseinrichtung vorzusehen, mittels der auch die Geschwindigkeit und Beschleunigung der Bewegung der Klappe berechnet werden kann. Dies gestattet es, das Antreiben der Klappe durch die Antriebsvorrichtung in Abhängigkeit der erfassten Größen der Klappe vorzunehmen. Auch hier ist ein entsprechender Einrückweg über Federpuffer vorzusehen. Eine weitere Alternative, die in der WO 2008/141348 A2 vorgeschlagen wird, sind kapazitive Schaltelemente, die berührungslos arbeiten.

Aufgabe der vorliegenden Erfindung ist es, ein Behältnis der eingangs genannten Art bereitzustellen, bei dem es ermöglicht wird, dass zum Auslösen der Antriebsvorrichtung ein möglichst geringer, vorzugsweise für den Benutzer nicht spürbarer, Weg zum Betätigen einer Betätigungsvorrichtung realisierbar ist.

Die Aufgabe wird erfindungsgemäß durch ein Behältnis nach Anspruch 1 gelöst.

Ein Verformungssensor weist mehrere Vorteile gegenüber herkömmlich eingesetzten Schaltelementen auf. Der Verformungssensor nimmt die Verformung eines Bauteils auf und gibt sie als Verformungssignal ab, wobei der Verlauf der Verformungsänderung abgelesen werden kann. Das bedeutet, dass nicht ein digitales Signal abgegeben wird, wie dies bei einem Schaltelement der Fall ist, sondern ein analoger Verlauf einer Verformung bzw. einer Verformungsänderung als Verformungssignal zur Verfügung steht. Mit dem Begriff "analog" ist nicht gemeint, dass das Verformungssignal nicht digital abgetastet und als digitales Signal weitergeleitet werden kann. Vielmehr ist damit gemeint, dass nicht nur zwei Zustände einer Messgröße, wie dies bei einem Schaltsignal (Ein/Aus) der Fall ist, gemessen werden können, sondern ein analoges Signal oder ein digital erfasstes Signal eines Verlaufs einer Messgröße mit einer Genauigkeit je nach digitaler Auflösung.

Dies hat den Vorteil, dass Einbautoleranzen der beiden Elemente zueinander und der Verformungsmesseinheit keinen Einfluss darauf haben, wann die Antriebsvorrichtung betätigt wird. Herkömmlich verwendete Schaltelemente weisen einen präzisen Schaltpunkt auf, bei dessen Erreichen bzw. Überschreiten der Schalter von einem Zustand in einen anderen Zustand umgeschaltet wird. Damit ist klar vorgegeben, bei welcher Position des Schaltelements die Antriebsvorrichtung betätigt wird. Die Lage dieses Schaltpunkts ist von den Einbautoleranzen abhängig. Insbesondere dann, wenn die Antriebsvorrichtung durch eine Kraftausübung auf ein Element des Behältnisses ausgelöst wird, also das Schaltelement indirekt, z.B. über eine Klappe des Behältnisses, geschaltet wird, ist somit der Schaltpunkt durch die Einbautoleranzen vorgegeben. Bei der Verwendung eines Verformungssensors ist dies nicht der Fall. Hier muss lediglich eine anfängliche Initialisierung stattfinden, so dass die Steuereinheit derart angelernt wird, dass sie bei gegebenen Einbauverhältnissen das in der Schließstellung anliegende Verformungssignal als Referenz vorliegen hat und ausgehend von diesem Referenzwert relative Verformungsänderungen verarbeiten kann.
Eines der Elemente, zum Beispiel das zweite Element, umfasst ein erstes Bauteil und ein zweites Bauteil, wobei die Verformungsmesseinheit zwischen den beiden Bauteilen angeordnet ist. Somit kann eine Verformung bzw. Verlagerung der beiden Bauteile zueinander erfasst werden.
Der Verformungssensor ist plattenförmig gestaltet und derart angeordnet, dass er bei Ausübung einer Kraft auf das erste Bauteil auf Biegung beansprucht wird. Alternativ, jedoch nicht erfindungsgemäß, kann auch ein Verformungssensor vorgesehen werden, der auf Druck beansprucht wird. Das erste Bauteil des zweiten Elements kann in Form einer Front und das zweite Bauteil in Form eines Trägerelements dargestellt sein, wobei das Trägerelement zum Beispiel ein Rahmen ist, der innerhalb des ersten Elements verfahrbar ist und die Front trägt.
Die Verformungsmesseinheit weist ein Aufnahmeelement auf, in dem der Verformungssensor angeordnet ist. Das Aufnahmeelement ist einerseits gegen das erste Bauteil und andererseits gegen das zweite Bauteil abgestützt.
Hierbei ist das Aufnahmeelement mit einem Druckabschnitt ausgebildet, gegen das das erste Bauteil abgestützt ist. Das Aufnahmeelement weist zwei Stützabschnitte auf, mit denen das Aufnahmeelement gegen das zweite Bauteil abgestützt ist. Der Verformungssensor ist auf einer ersten Seite gegen den Druckabschnitt und auf einer der ersten Seite abgewandten zweiten Seite gegen die Stützabschnitte abgestützt. Somit kann bei einer Verlagerung des Druckabschnitts relativ zu den beiden Stützabschnitten eine Verformung des Verformungssensors stattfinden.
Da der Verformungssensor relative Verformungsänderungen aufnimmt, ist vorgesehen, dass der Verformungssensor zwischen dem Druckabschnitt und den Stützabschnitten vorgespannt gehalten ist. Somit wird stets ein Verformungssignal erzeugt, auch wenn noch keine Verformung der beiden Bauteile zueinander oder eines der Bauteile stattfindet. Somit wird ein möglicherweise vorhandenes Spiel beseitigt, welches zu Messungenauigkeiten führen würde.
Der Druckabschnitt kann einen Befestigungsabschnitt aufweisen, wobei Befestigungsvorsprünge des zweiten Bauteils zwischen dem Befestigungsabschnitt und den Stützabschnitten eingespannt sind. Bei einer Ausübung einer Kraft im Bereich zwischen den beiden Stützabschnitten wird eine Verformung des Aufnahmeelements bewirkt, welche vom Verformungssensor aufgenommen werden kann.
Vorzugsweise handelt es sich bei dem Behältnis um einen Schrank oder ein Haushaltsgerät, insbesondere ein vollintegriertes Küchengerät. Das erste Element kann ein Korpus und das zweite Element ein gegenüber dem Korpus bewegbar gehaltenes Element, insbesondere ein Auszug sein.
Bei dem Verformungssensor handelt es sich vorzugsweise um einen Sensor zur Aufnahme einer relativen Verformungsänderung, insbesondere ein Piezoelement mit einem Piezokristall, oder einen Dehnungsmessstreifen. Piezoelemente und Dehnungsmessstreifen haben den Vorteil, dass sie Verformungssignale ermöglichen, die bereits bei Verformungen ausgewertet werden können, die von einem Benutzer nicht wahrgenommen werden.

Die Verformungsmesseinheit kann nicht erfindungsgemäß auch an einem Bauteil, insbesondere an einer Front, eines der Elemente angeordnet sein. Die Verformung kann zum Beispiel mittels eines Dehnungsmessstreifens an einer Front des zweiten Elements erfasst werden. Ebenso ist es prinzipiell, jedoch nicht erfindungsgemäß, denkbar, dass die Verformungsmesseinheit am ersten Element, zum Beispiel an oder in einem Korpus, angeordnet ist, wobei selbst bei einer Kraftausübung auf das zweite Element die Verformung im ersten Element erfasst werden kann, sofern sich das zweite Element gegen das erste Element abstützt. Somit kann die Verformungsmesseinheit derart angeordnet werden, dass sie für einen Benutzer nicht sichtbar in Erscheinung tritt. Ein Verfahren zum Auslösen einer Antriebsvorrichtung eines Behältnisses nach einer der vorangehenden Art beinhaltet, dass der Verlauf der relativen Verformungsänderung anhand des Verformungssignals ausgewertet wird und bei Erfüllen vorbestimmter Bedingungen die Antriebsvorrichtung betätigt wird. Hierbei wird das Verformungssignal vorzugsweise derart ausgewertet, dass ein unbeabsichtigtes Betätigen der Antriebsvorrichtung verhindert wird. Je nach Art der Kraftausübung ergibt sich ein bestimmter Verlauf des Verformungssignals, wobei anhand des Verlaufs des Verformungssignals zwischen unterschiedlichen Krafteinwirkungen unterschieden werden kann. So ist beispielsweise die Kraftausübung auf die Verformungsmesseinheit, auch zum Beispiel über das zweite Element, bei einer schaltenden Bewegung einer Person deutlich von dem Verlauf des Verformungssignals unterscheidbar, welches bei einem unbeabsichtigten Schlagen oder Anlehnen gegen das zweite Element entsteht.
Bevorzugte Ausführungsbeispiele werden im folgenden anhand der Figuren näher erläutert und hierin zeigen:
- Figur 1: eine perspektivische Darstellung eines Schranks mit einem Korpus und einem Auszug;
- Figur 2: eine perspektivische Darstellung einer Verformungsmesseinheit für die Verwendung in einem Schrank gemäß Figur 1;
- Figur 3: ein Querschnitt entlang der Schnittlinie VII - VII gemäß Figur 2 und
- Figur 4: einen Querschnitt durch einen Teil des Auszugs des Schranks gemäß Figur 1.

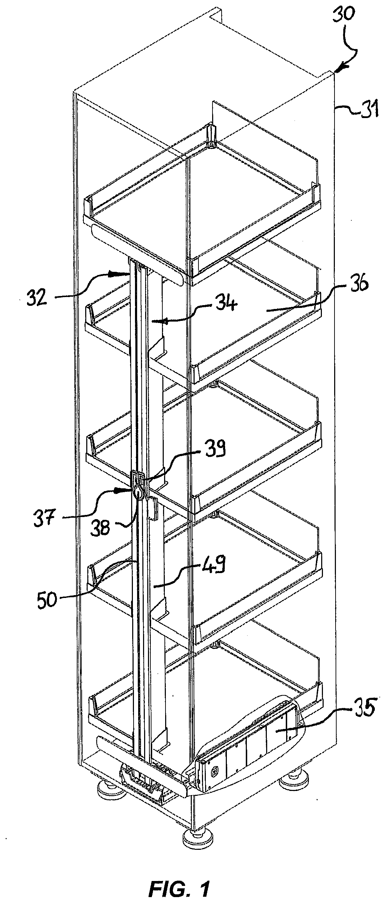

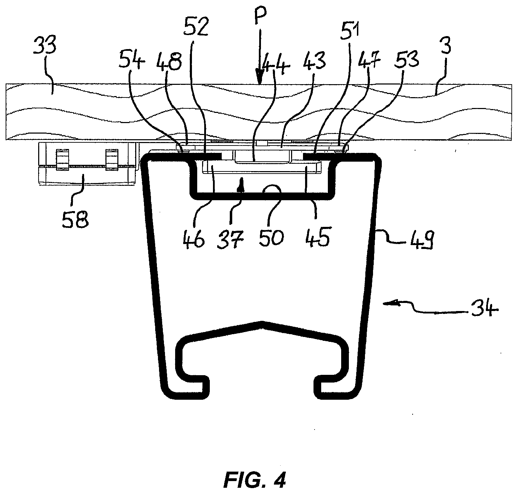

In den Figuren 1 bis 4 ist eine Ausführungsform eines erfindungsgemäßen Behältnisses in Form eines Schranks 30 mit einem ersten Element in Form eines Korpus 31 und einem zweiten Element in Form eines Auszugs 32 dargestellt. In Figur 1 ist der Korpus 31 schematisch durch Andeutung der Außenkanten dargestellt. Der Auszug 32 umfasst eine Front 33 (Fig. 4) und ein Trägerelement 34. Das Trägerelement 34 ist linear verstellbar innerhalb des Korpus 31 angeordnet und wird durch eine Antriebsvorrichtung 35 elektrisch angetrieben, so dass durch Betätigung der Antriebsvorrichtung 35 der Auszug 32 aus dem Korpus 31 heraus und wieder in diesen hinein gefahren werden kann. Denkbar ist ebenso eine Lösung, bei der der Auszug nur ein Stück aus dem Korpus 31 ausgestoßen wird und die weitere Bewegung freilaufend oder manuell erfolgt. An dem Trägerelement 34 sind mehrere Tablare 36 zum Aufbewahren von Gegenständen angeordnet. Zwischen der Front 33 und dem Trägerelement 34 ist eine Verformungsmesseinheit 37 vorgesehen, mittels derer die Antriebsvorrichtung 35 betätigt werden kann.

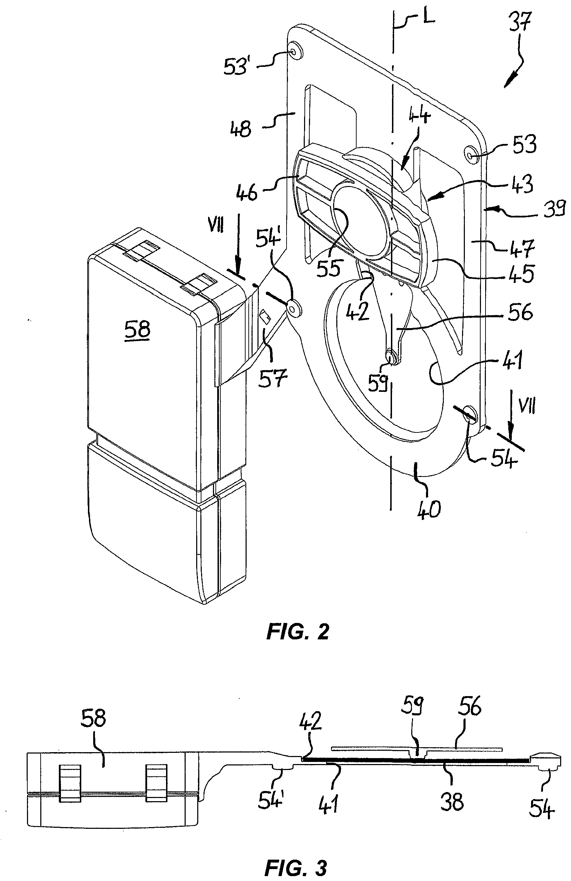

Die Verformungsmesseinheit 37 ist in den Figuren 2 bis 4 detailliert dargestellt. Die Verformungsmesseinheit 37 umfasst einen Verformungssensor 38, der plattenförmig gestaltet ist. Der Verformungssensor 38 ist der Übersichtlichkeit halber in Figur 2 nicht dargestellt. Die Verformungsmesseinheit 37 umfasst ferner ein Aufnahmeelement 39, welches rahmenförmig gestaltet ist. Der Verformungssensor 38 ist an dem Aufnahmeelement 39 befestigt. Hierzu weist das Aufnahmeelement 39 einen Fixierabschnitt 40 mit einem kreisrunden Durchbruch 41 auf. Zu einer Seite hin weist der Durchbruch 41 eine ringförmige Fixierausnehmung 42 auf, in welche der Verformungssensor 38 eingesetzt werden kann. Ein Druckarm 56 mit einem zentralen Druckvorsprung 59 ragt radial vom Rand des Durchbruchs 41 bis zum Zentrum des Durchbruchs 41, wobei der Verformungssensor 38 zwischen dem Druckarm 56 und der Fixierausnehmung 42 angeordnet ist bzw. durch den Druckarm 56, der sich mit seinem Druckvorsprung 59 gegen den Verformungssensor 38 abstützt, in der Fixierausnehmung 42 gehalten ist. Somit ist der Verformungssensor 38 an dem Aufnahmeelement 39 fixiert.

Das Aufnahmeelement 39 weist ferner einen Druckabschnitt 43 auf, welcher zentral zu einer Längsachse L des Aufnahmeelements 39 angeordnet ist. Der Druckabschnitt 43 weist einen Befestigungsabschnitt 44 auf, der zwei jeweils zu einer Seite der Längsachse L vorstehende Laschen 45, 46 umfasst.

Beidseitig zur Längsachse L sind zwei Stützabschnitte 47, 48 des Aufnahmeelements 39 vorgesehen.

Zur Befestigung des Aufnahmeelements 39 weist das Trägerelement 34 einen vertikal verlaufenden Holm 49 mit einer ebenfalls vertikal verlaufenden Befestigungsnut 50 auf. Die Befestigungsnut 50 weist zur Front 33. Die Befestigungsnut 50 ist entlang ihrer Längserstreckung beidseitig durch plattenförmige Befestigungsvorsprünge 51, 52 flankiert, die zusammen mit der Befestigungsnut 50 jeweils einen Hinterschnitt bilden. Das Aufnahmeelement 39 ist derart mit dem Befestigungsabschnitt 44 in die Befestigungsnut 50 eingeführt, dass die Laschen 45, 46 die Befestigungsvorsprünge 51, 52 hintergreifen, wobei die Laschen 45, 46 sich auf der der Befestigungsnut 50 zugewandten Seite der Befestigungsvorsprünge 51, 52 gegen letztere abstützen. Die Stützabschnitte 47, 48 stützen sich auf der den Laschen 45, 46 abgewandten Seite der Befestigungsvorsprünge 51, 52 an dem Holm 49 ab. Das Aufnahmeelement 39 ist hierbei vorzugsweise derart dimensioniert, dass die Befestigungsvorsprünge 51, 52 mit Vorspannung zwischen den Laschen 45, 46 und den Stützabschnitten 47, 48 eingeklemmt sind.

Hierbei ist das Aufnahmeelement 39 zwischen dem Holm 49 des Trägerelements 34 und der Front 33 angeordnet, so dass durch eine Kraftausübung in Krafteinleitungsrichtung P das Aufnahmeelement 39 über den Druckabschnitt 43, mit dem das Aufnahmeelement 39 gegen die Front 33 abgestützt ist, verformt wird, wobei diese Verformung auf den Verformungssensor 38 übertragen wird. Bei einer Verformung in Richtung der Krafteinleitungsrichtung P wird der Befestigungsabschnitt 44 tiefer in die Befestigungsnut 50 hineingedrückt, wobei die Laschen 45, 46 von den Befestigungsvorsprüngen 51, 52 abheben. Um diese Verformung zu begünstigen, weisen die Stützabschnitte 47, 48 Stützvorsprünge 53, 53', 54, 54' auf, welche in Richtung zum Holm 49 von den Stützabschnitten 47, 48 vorstehen und über die die Stützabschnitte 47, 48 gegen den Holm 49 abgestützt sind. Die Stützvorsprünge 53, 53', 54, 54' sind noppenförmig gestaltet und bilden somit Drehpunkte, um die das Aufnahmeelement 39 bei der Verformung schwenken kann.

Der Befestigungsabschnitt 44 umfasst ferner eine Bohrung 55, welche mit der Befestigungsnut 50 fluchtet und von dieser ausgehend in Richtung zur Front 33 verläuft. Über die Bohrung 55 kann der Befestigungsabschnitt 44 mit der Front 33 fest verschraubt oder anderweitig fest verbunden werden. Somit kann auch eine Krafteinleitung entgegen der Krafteinleitungsrichtung P bewirkt werden, wobei sich in dieser Richtung die Laschen 45, 46 gegen die Befestigungsvorsprünge 51, 52 abstützen und keine Verformung des Aufnahmeelements 39 entsteht. Somit kann die Verformungsmesseinheit 47 auch für Auszüge 32 verwendet werden, die eine Zugstange auf der vom Holm 49 abgewandten Seite der Front 33 aufweisen. Die Verformungsmesseinheit 47 verhält sich somit in Richtung der Krafteinleitungsrichtung P elastisch und entgegen der Krafteinleitungsrichtung P steif.

Der Druckarm 56 am Druckabschnitt 43 dient auch der besseren Übertragung der Verformungen des Aufnahmeelements 39 auf den plattenförmigen Verformungssensor 38. Der Druckarm 56 ragt radial in den Durchbruch 41 hinein und stützt sich zentral gegen den Verformungssensor 38 ab. Somit wird eine Druckkraft, die in Krafteinleitungsrichtung P auf die Front ausgeübt wird, zentral auf den Verformungssensor 38 übertragen und gewährleistet eine ausreichende Verformung des Verformungssensors 38 auch bei geringen Drücken.

Das Aufnahmeelement 39 weist einen Steg 57 auf, an dessen Ende eine Steuereinheit 58 befestigt ist. Die Steuereinheit 58 empfängt über eine herkömmliche Datenverbindung das Verformungssignal des Verformungssensors 38 und verarbeitet dieses. Ferner ist die Steuereinheit 58 mit der Antriebsvorrichtung 35 über eine Datenverbindung, wie zum Beispiel eine Kabelleitung oder eine Funkverbindung, verbunden, um die Antriebsvorrichtung 35 betätigen zu können.

### Bezugszeichenliste

- 30: Schrank
- 31: Korpus
- 32: Auszug
- 33: Front
- 34: Trägerelement
- 35: Antriebsvorrichtung
- 36: Tablar
- 37: Verformungsmesseinheit
- 38: Verformungssensor
- 39: Aufnahmeelement
- 40: Fixierabschnitt
- 41: Durchbruch
- 42: Fixierausnehmung
- 43: Druckabschnitt
- 44: Befestigungsabschnitt
- 45: Lasche
- 46: Lasche
- 47: Stützabschnitt
- 48: Stützabschnitt
- 49: Holm
- 50: Befestigungsnut
- 51: Befestigungsvorsprung
- 52: Befestigungsvorsprung
- 53: Stützvorsprung
- 54: Stützvorsprung
- 55: Bohrung
- 56: Druckarm
- 57: Steg
- 58: Steuereinheit
- 59: Druckvorsprung

- L: Längsachse
- P: Krafteinleitungsrichtung

## Patentansprüche

1. Behältnis (30) umfassend
ein erstes Element (31) und zumindest ein zum ersten Element (31) zwischen einer Schließstellung und einer Offenstellung bewegbares zweites Element (32),
eine Antriebsvorrichtung (35) zum Bewegen des zweiten Elements (32), zumindest eine Verformungsmesseinheit (37) mit einem Verformungssensor (38) an zumindest einem der Elemente (31, 32) zum Aufnehmen einer auf eines der Elemente (31, 32) ausgeübten Kraft und
eine Steuereinheit (58) zum Empfangen und Auswerten eines von der Verformungsmesseinheit (37) übermittelten Verformungssignals und zum Betätigen der Antriebsvorrichtung (35),
wobei eines der Elemente (32) ein erstes Bauteil (33) und ein zweites Bauteil (34) umfasst,
wobei die Verformungsmesseinheit (37) zwischen den beiden Bauteilen (33, 34) angeordnet ist,
wobei der Verformungssensor (38) plattenförmig gestaltet ist und derart angeordnet ist, dass er bei Ausübung einer Kraft auf das erste Bauteil (33) auf Biegung beansprucht wird,
wobei die Verformungsmesseinheit (37) ein Aufnahmeelement (39) aufweist, an dem der Verformungssensor (38) aufgenommen ist, und
wobei das Aufnahmeelement (39) einerseits gegen das erste Bauteil (33) und andererseits gegen das zweite Bauteil (34) abgestützt ist,
**dadurch gekennzeichnet,**
**dass** das Aufnahmeelement (39) mit einem Druckabschnitt (43) gegen das erste Bauteil und mit zwei Stützabschnitten (47, 48) gegen das zweite Bauteil (34) abgestützt ist,
**dass** der Verformungssensor (38) auf einer ersten Seite gegen den Druckabschnitt (43) und auf einer der ersten Seite abgewandten zweiten Seite gegen die Stützabschnitte (47, 48) abgestützt ist, und
**dass** der Verformungssensor (38) zwischen dem Druckabschnitt (43) und den Stützabschnitten (47, 48) vorgespannt gehalten ist.

2. Behältnis nach Anspruch 1,
**dadurch gekennzeichnet,**
**dass** der Druckabschnitt (43) einen Befestigungsabschnitt (44) aufweist, wobei Befestigungsvorsprünge (51, 52) des zweiten Bauteils (34) zwischen dem Befestigungsabschnitt (44) und den Stützabschnitten (47, 48) eingespannt sind.

3. Behältnis nach einem der vorangehenden Ansprüche,
**dadurch gekennzeichnet,**
**dass** das Behältnis ein Schrank (30) oder ein Haushaltsgerät, insbesondere ein vollintegriertes Küchengerät, ist,
**dass** das erste Element ein Korpus (31) ist und
**dass** das zweite Element ein gegenüber dem Korpus (31) bewegbar gehaltenes Element, insbesondere ein Auszug (32), ist.

4. Behältnis nach einem der vorangehenden Ansprüche,
**dadurch gekennzeichnet,**
**dass** der Verformungssensor (38) ein Sensor zur Aufnahme einer relativen Verformungsänderung ist und insbesondere ein Piezoelement oder einen Dehnungsmessstreifen umfasst.

5. Behältnis nach einem der vorangehenden Ansprüche,
**dadurch gekennzeichnet,**
**dass** das zweite Element (32) das erste Bauteil in Form einer Front (33) und das zweite Bauteil in Form eines Trägerelements (34) umfasst.

## Claims

1. A container (30) comprising
a first element (31) and at least one second element (32) movable relative to the first element (31) between a closed position and an open position, a drive device (35) for moving the second element (32),
at least one deformation measuring unit (37) with a deformation sensor (38) on at least one of the elements (31, 32) for detecting a force exerted on one of the elements (31, 32) and
a control unit (58) for receiving and evaluating a deformation signal transmitted by the deformation measuring unit (37) and for actuating the drive device (35),
wherein one of the elements (32) comprises a first component (33) and a second component (34),
wherein the deformation measuring unit (37) is arranged between the two components (33, 34),
wherein the deformation sensor (38) is plate-like and is arranged such, that it is bent during a force exerted on the first component (33),
wherein the deformation measuring unit (37) has an accommodation element (39) accommodating the deformation sensor (38), and
wherein the accommodation element (39) is supported against the first component (33) and against the second component (34),
**characterised in**
**that** the accommodation element (39) is supported with a pressure portion (43) against the first component and with two support portions (47, 48) against the second component (34),
**that** the deformation sensor (38) is supported, on a first side, against the pressure portion (43) and, on a second side facing away from the first side, against the support portions (47, 48), and
**that** the deformation sensor (38) is held preloaded between the pressure portion (43) and the support portions (47, 48).

2. Container according to claim 1,
**characterised in**
**that** the pressure portion (43) has an attachment portion (44), wherein attachment projections (51, 52) of the second component (34) are clamped between the attachment portion (44) and the support portions (47, 48).

3. Container according to one of the preceding claims,
**characterised in**
**that** the container is a cabinet (30) or a household appliance, in particular a fully integrated kitchen appliance,
**that** the first element is a cabinet body (31) and
**that** the second element is a closing element, in particular a drawer, movably held relative to the cabinet body.

4. Container according to one of the preceding claims,
**characterised in**
**that** the deformation sensor (38) is a sensor for detecting a relative deformation change and particularly has a piezo element or a strain gauge.

5. Container according to one of the preceding claims,
**characterised in**
**that** the second element (32) has the first component in form of a front (33) and the second component in form of a support element (34).

## Revendications

1. Conteneur (30) comprenant
un premier élément (31) et au moins un deuxième élément (32) mobile vers le premier élément (31) entre une position de fermeture et une position d'ouverture, un dispositif d'entraînement (35) pour déplacer le deuxième élément (32),
au moins une unité de déformation (37) avec un capteur de déformation (38) sur au moins un des éléments (31,32) pour enregistrer une force exercée sur un des éléments (31,32), et
une unité de commande (58) pour recevoir et exploiter un signal de déformation transmis par l'unité de déformation (37) et pour actionner le dispositif d'entraînement (35),
un des éléments (32) comprenant un premier composant (33) et un deuxième composant (34),
l'unité de déformation (37) étant disposée entre les deux composants (33,34),
le capteur de déformation (38) étant structuré en forme de plaque et disposé de telle manière qu'il est sollicité en flexion lors de l'exercice d'une force sur le premier composant (33),
l'unité de déformation (37) comportant un élément de logement (39) sur lequel est logé le capteur de déformation (38), et
l'élément de logement (39) étant appuyé d'une part contre le premier composant (33) et d'autre part contre le deuxième composant (34),
**caractérisé en ce que**
l'élément de logement (39) est appuyé avec une section de pression (43) contre le premier composant et avec deux sections d'appui (47,48) contre le deuxième composant (34),
**en ce que** le capteur de déformation (38) est appuyé sur un premier côté contre la section de pression (43) et sur un deuxième côté opposé au premier côté contre les sections d'appui (47,48), et
**en ce que** le capteur de déformation (38) est maintenu en précontrainte entre la section de pression (43) et les sections d'appui (47,48).

2. Conteneur selon la revendication 1, **caractérisé en ce que** la section de pression (43) comporte une section de fixation (44), les saillies de fixation (51,52) du deuxième composant (34) étant serrées entre la section de fixation (44) et les sections d'appui (47,48).

3. Conteneur selon l'une quelconque des revendications précédentes, **caractérisé en ce que** le conteneur est une armoire (30) ou un appareil ménager, notamment un appareil de cuisine complètement intégré,
**en ce que** le premier élément est un corps (31), et
**en ce que** deuxième élément est un élément maintenu mobile par rapport au corps (31), notamment une rallonge (32),

4. Conteneur selon l'une quelconque des revendications précédentes, **caractérisé en ce que** le capteur de déformation (38) est un capteur pour enregistrer une modification de déformation relative et notamment un élément piézoélectrique ou une jauge extensométrique.

5. Conteneur selon l'une quelconque des revendications précédentes, **caractérisé en ce que** le deuxième élément (32) comprend le premier composant sous la forme d'un avant (33) et le deuxième composant sous la forme d'un élément porteur (34).
